## Europäisches Patentamt
## European Patent Office
## Office européen des brevets

(11) Publication number: **0 136 880**
**B1**

(12) **EUROPEAN PATENT SPECIFICATION**

(45) Date of publication of patent specification: **16.12.87**

(51) Int. Cl.⁴: **H 01 L 27/10**, H 01 L 29/06

(21) Application number: **84306557.4**

(22) Date of filing: **26.09.84**

(54) Gate array type semiconductor integrated circuit device.

(30) Priority: **30.09.83 JP 182069/83**

(43) Date of publication of application:
**10.04.85 Bulletin 85/15**

(45) Publication of the grant of the patent:
**16.12.87 Bulletin 87/51**

(84) Designated Contracting States:
**DE FR GB**

(56) References cited:
**EP-A-0 009 782**
**EP-A-0 105 985**
**GB-A-1 502 130**

(73) Proprietor: **FUJITSU LIMITED**
**1015, Kamikodanaka Nakahara-ku**
**Kawasaki-shi Kanagawa 211 (JP)**

(72) Inventor: **Takayama, Yoshihisa**
**Sasamoto-so No. 2 1292, Kamikodanaka**
**Nakahara-ku**
**Kawasaki-shi Kanagawa 211 (JP)**
Inventor: **Fujii, Shigeru**
**5-27-6-403, Kirigaoka Midori-ku**
**Yokohama-shi Kanagawa 227 (JP)**
Inventor: **Tanabe, Tomoaki**
**59-8, Shiratoridai Midori-ku**
**Yokohama-shi Kanagawa 227 (JP)**

(74) Representative: **Rackham, Stephen Neil et al**
**GILL JENNINGS & EVERY 53-64 Chancery Lane**
**London WC2A 1HN (GB)**

Courier Press, Leamington Spa, England.

## Description

The present invention relates to a semiconductor integrated circuit (IC) device, more particularly, to a semiconductor IC device of the gate array type fabricated with complementary metal insulator semiconductor (CMIS) transistors.

The recent increase in scale of IC's and the change in user needs to small-lots of large scale integrated (LSI) semiconductor devices have led to increased emphasis on the so-called masterslice LSI semiconductor device as a means of reducing manufacturing costs and manufacturing time.

In a masterslice semiconductor device, as is well known, many basic element sets are formed in advance in a semiconductor chip. Each basic element set is fabricated with usual transistors, resistors, and so on to form a basic circuit (hereinafter referred to as a basic cell). The masterslice semiconductor device is mass produced. Interconnecting lines are then formed between the basic cells and in each basic cell using a specified mask to obtain an LSI semiconductor device with the desired functional circuits.

This technique enables significant reductions in both design and manufacturing time since one need only design and fabricate the masks when manufacturing a new LSI semiconductor device. Furthermore, in a masterslice semiconductor device, since a large number of basic cells are regularly arranged in both the column and row directions on the semiconductor substrate and form a standardized matrix pattern, it is very easy to employ so-called computer aided automatic wiring for forming the interconnecting wiring lines.

Such a standardized matrix pattern is usually called a "gate array". Of the different type of gate arrays, a CMIS gate array is most widely used for LSI semiconductor devices. The basic cells of such an array each comprise CMIS transistors. CMIS transistor have the advantage of low-power operation and, therefore, provide higher integration of the LSI semiconductor device.

CMIS gate array type LSI semiconductor devices, however, suffer from the problem of "latchup". In the latchup phenomenon, a parasitic silicon-controlled rectifier (SCR) is created in the substrate. This SCR, when remaining on, can break the interconnecting lines and damage the basic cells.

In the prior art, latchup has been eliminated by providing a gate array type of semiconductor integrated circuit device formed in a semiconductor substrate, comprising an array of basic cells arranged in columns and rows with column spaces between adjacent columns and row spaces between adjacent rows, each of the basic cells including a first-channel MIS transistor formed in the silicon substrate of one conductivity type and a second-channel MIS transistor formed in a well of other conductivity type; a plurality of first diffusion regions of one conductivity type in contact with the semiconductor substrate and located in the row spaces between adjacent basic cells, the first diffusion regions being ohmically connected with a first power line, and a plurality of second diffusion regions of the other conductivity type in contact with the wells and located in the row spaces between adjacent basic cells, the second diffusion regions being ohmically connected with a second power line.

The $n^+$- and $p^+$-diffusion regions formed in the n-type silicon substrate and p-type well respectively, between each two adjacent p-channel transistors and each two adjacent n-channel transistors of the basic cell array, respectively prevents the formation of the parasitic SCR. However, the insertion of the $n^+$- and $p^+$-diffusion regions between each two adjacent basic cells impedes higher densities of packing of the basic cells and thus reduces the integration degree of the device.

According to this invention in such a gate array device both the first and second diffusion regions have a comb-shaped structure arranged with its base along the column spaces and its teeth along the row spaces.

Particular examples of gate array devices in accordance with this invention will now be described and contrasted with conventional devices with reference to the accompanying drawings; in which:—

Figure 1 is a circuit diagram of a conventional basic cell used in a CMIS gate array type LSI semiconductor device;

Figure 2 is an enlarged top plan of the conventional basic cell;

Figure 3 is a top plan of a basic cell arrangement on a semiconductor chip;

Figure 4 is a cross-section and an equivalent circuit diagram to explain the latchup phenomenon;

Figure 5 is an enlarged top plan of part of the basic cell shown in Figure 3;

Figures 6A and 6B schematically show the basic structures of two diffusion regions used in the present invention;

Figure 7A is an enlarged top plan of a part of a basic cell array according to a first example of the present invention;

Figure 7B is an enlarged cross-section taken along line B—B of Figure 7A;

Figure 7C is an enlarged cross-section taken along line C—C of Figure 7A;

Figure 7D is an enlarged cross-section taken along line D—D of Figure 7A;

Figure 8 is an enlarged top plan of part of a basic cell array according to a second example of the present invention; and,

Figure 9 is a top plan of an example of a gate array type semiconductor IC device including the diffusion regions according to the first embodiment.

Before describing the preferred embodiments, a discussion will be made of a prior art semiconductor IC device for reference purposes.

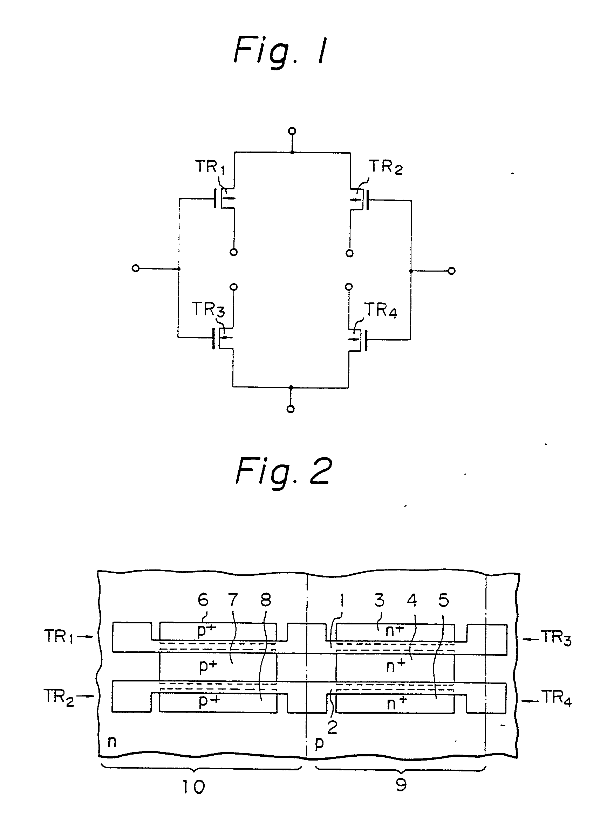

Figure 1 is a circuit diagram of a conventional basic cell used in a CMIS gate array type LSI semiconductor device. The basic cell of Figure 1, known from US—A—4,412,237 comprises two p-channel MIS transistors $TR_1$, $TR_2$ and two n-channel MIS transistors $TR_3$, $TR_4$. Each two MIS transistors of the same channel have a common source or drain. In addition, each two MIS transistors of different channels have common gates.

Figure 2 is an enlarged top plan view of the basic cell shown in Figure 1 formed on a semiconductor substrate. Specifically, the pattern of the regions with impurities and the pattern of the gate electrodes for realizing the basic cell are illustrated in Figure 2. Reference numeral 1 represents a first gate electrode wiring layer, made of, for example, polycrystalline silicon, and 2 a second gate electrode wiring layer, also made polycrystalline silicon. Reference numerals 3, 4 and 5 represent $n^+$-type regions for forming the source or drain of the n-channel transistors. Reference numerals 6, 7, and 8 represent $p^+$-type regions for forming the source or drain of the p-channel transistors. Reference numeral 9 represents an island-like p-type region, i.e., a so-called p-type well, and 10 an n-type silicon substrate.

In the CMIS gate array type LSI semiconductor device, a large number of basic cells, each having the construction as mentioned above, are arranged on a single semiconductor chip in linear arrays. When the basic cells are arranged in a column direction, spaces, for interconnecting lines are secured for each basic cell in the row direction. Similar spaces are also formed between each two adjacent basic cells in the column direction.

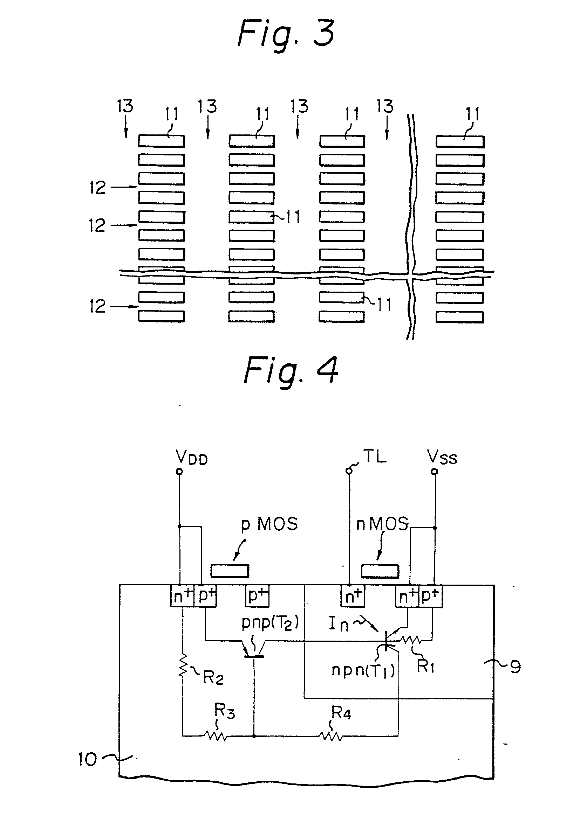

Figure 3 is a top plan view of a basic cell arrangement on a semiconductor chip. In Figure 3, reference numeral 11 represents basic cells as explained in detail before. Spaces 12 are formed between these basic cells 11 for arranging interconnecting lines in the row direction. At the same time, spaces 13 are formed for arranging interconnecting lines in the column direction.

In the arrangement of Figure 3, each of the basic cell arrays includes tens to hundreds of basic cells in the column direction. Tens of the basic cell arrays are arranged in the row direction. The width of each row space 12 is determined so that one to four interconnecting lines can be accommodated therein, while the width of each column space 13 is determined so that ten to several tens of interconnecting lines can be accommodated therein.

The present invention is directed to the elimination of latchup in the highly dense packing of basic cells 11 as shown in Figure 3. Figure 4 is a cross-sectional view and equivalent circuit diagram for explaining the latchup phenomenon. In the CMIS transistor structure, when a voltage $V_{DD}$ is supplied to the p-channel MIS transistors pMIS and a voltage $V_{SS}$ is supplied to the n-channel MIS transistor nMIS, a parasitic npn transistor $T_1$ is formed in the p-type well at the nMIS side and a parasitic pnp transistor $T_2$ is formed in the n-type silicon substrate 10 at the pMIS side. Further, parasitic resistors $R_1$, $R_2$, $R_3$ and $R_4$ are defined between each emitter, base and collector of the parasitic transistors $T_1$ and $T_2$. As apparent from the equivalent circuit diagram, the parasitic transistors and the parasitic resistors provide a thyristor structure. Latchup is caused by the thus formed thyristor.

Specifically, if a noise current In having a relatively large amplitude is given from an external or internal terminal TL via the $n^+$-type region, the parasitic transistor $T_1$ is turned on, and a current starts flowing therethrough from the terminal of $V_{DD}$ to the terminal of $V_{SS}$ via the parasitic resistors $R_2$, $R_3$ and $R_4$. Therefore, the voltage level between the resistors $R_3$ and $R_4$ becomes lower than the base voltage level of the transistor $T_2$, and, thus, the transistor $T_2$ is turned on. As a result, a positive feedback loop is created between the parasitic transistors $T_1$ and $T_2$, and, accordingly, the thyristor is rendered to a low resistance state. This means that once a large noise current In is given, even momentarily, a considerably large current is continually generated between the $V_{DD}$ and $V_{SS}$ terminals. This is the latchup phenomenon.

This abnormal current continues until the power ($V_{DD}$, $V_{SS}$) is turned off therefrom. Therefore, if the power is turned off and then on, the CMIS transistor is restored to its normal state. However, if the power is not once turned off and the abnormal state is left as it is, the interconnecting lines may break and the basic cells may be damaged.

The higher the density of packing of the basic cells due to miniaturization of the CMIS transistors, the greater the chance of the latchup. This is because the greater the miniaturization and the higher the density of packing of the basic cells, the greater the probability of the creation of parasitic transistors and resistors.

It is known that, in order to increase the resistance to latchup, the resistance values of the parasitic resistors $R_1$, $R_2$, $R_3$ and $R_4$ can be reduced by lowering the resistance values of the n-type silicon substrate 10 itself and the p-type well 9 itself. For this, an $n^+$-diffusion region and a $p^+$-diffusion region are formed respectively in the surface layers of the n-type silicon substrate 10 and p-type well 9, for contact therewith in the vicinity of each transistor pMIS and each transistor nMIS.

In the prior art CMIS gate, array type LSI semiconductor device, the $n^+$- and $p^+$-diffusion regions for contact with the substrate 10 and the well 9, respectively, are formed independently in each row space 12 between each two adjacent basic cells 11. Therefore, each diffusion region must make contact with the power lines of $V_{DD}$ and $V_{SS}$. This increases the width of each diffusion region and, therefore, necessitates that the basic cells in each basic cell array be separated in the column direction with a wide pitch. This impedes higher density of packing.

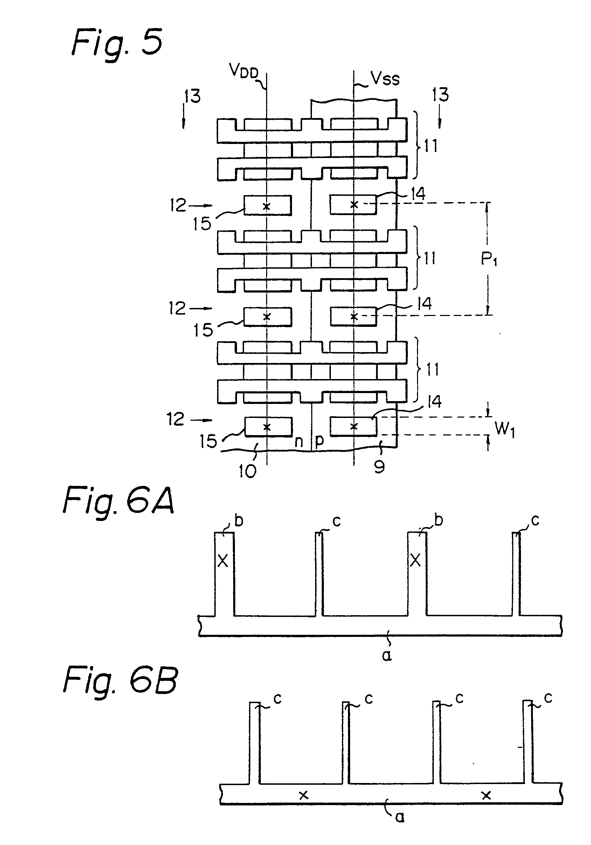

Figure 5 is an enlarged top plan view of the partial basic cell array shown in Figure 3. In Figure 5, members the same as those of previous figures are represented by the same reference numerals or symbols (same for later figures). As seen from Figure 5, the prior art $n^+$-diffusion regions 15 for contacting the n-type silicon substrate 10 are formed independently between each two adjacent basic cells 11. Similarly, the prior art $p^+$-diffusion regions 14 for contacting the p-type well 9 are formed independently between each two adjacent basic cells 11. In each of the diffusion regions 14 and 15, the symbol "X" denotes an ohmic contact for connection to the power line of $V_{DD}$ or $V_{SS}$. As clear from Figure 5, the existence of the ohmic contact at each diffusion region (14, 15) increases the width of the regions and, in this sense impedes higher density of packing of the basic cells.

Figure 6A and Figure 6B schematically show basic structures of a first type diffusion region and second type diffusion region according to the present invention. As apparent from Figures 6A and 6B, the diffusion regions of the present invention for contact with the n-type silicon substrate and the p-type well are comb-shaped in overall structure. In Figure 6A, the first type comb-shaped diffusion region is shaped with a base part a, wide tooth parts b, and narrow tooth parts c. Each wide tooth part 6 contains an ohmic contact X for contact with the power line. In Figure 6B, the second type comb-shaped diffusion region is shaped with the base part a and the narrow tooth parts c. The base part a contains the ohmic contacts X.

In Figures 6A and 6B, it is important to note that all of the diffusion regions 14, 15 or some of the diffusion regions 14, 15, are replaced with the narrow tooth parts c. In this case, the narrow tooth parts are still supplied with power level from the ohmic contacts X via the base part a (Figure 6B) or via both the wide tooth parts b and the base part a (Figure 6A). Accordingly, each two adjacent basic cells straddling a narrow tooth part c can be located closer to each other than those straddling the wide diffusion regions 14, 15 as in Figure 5. This makes it possible to pack the basic cells with higher density than in the prior art.

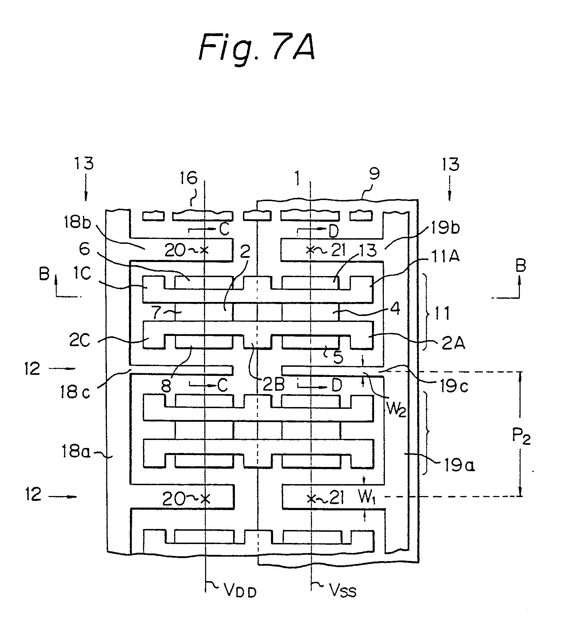

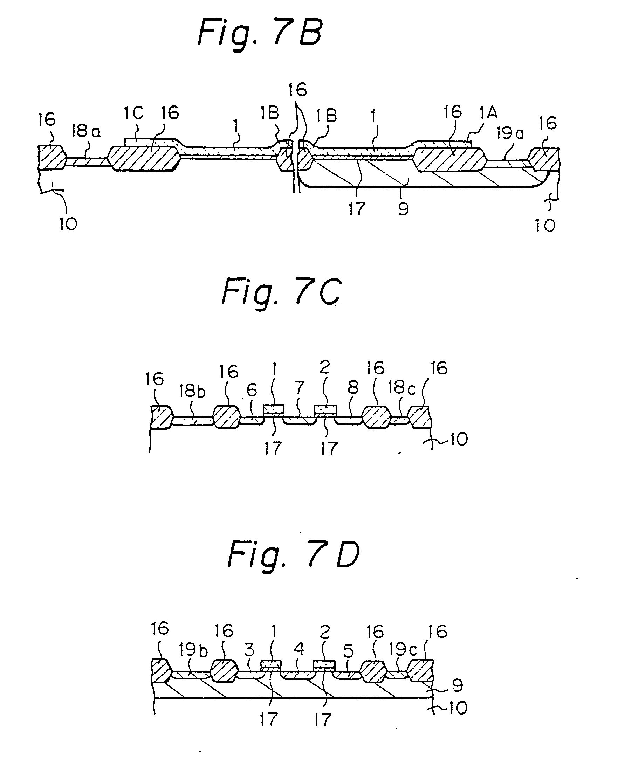

Figure 7A is an enlarged top plan view of a partial basic cell array according to a first embodiment of the present invention. Figure 7D is an enlarged cross-sectional view taken along line D—D of Figure 7A. Members 1 through 13 in Figures 7A through 7D, have already been explained. Reference numerals 1A, 1B, and 1C represent three different terminal electrodes provided by the first gate electrode wiring layer 1. Similarly, 2A, 2B, and 2C represent three different terminal electrodes provided by the second gate electrode wiring layer 2. Reference numeral 16 represents an isolation layer for separation and 17 a gate insulation layer. Reference numeral 18 represents an $n^+$-diffusion region for contact with the n-type silicon substrate 10, and reference numeral 19 represents a $p^+$-diffusion region for contact with the p-type well 9. Both regions 18 and 19 are features of the present invention. To be specific, reference numeral 18a represents a base part of the region 18, 18b wide tooth parts of the region 18, and 18c narrow tooth parts of the region 18. Thus, the members 18a, 18b, and 18c form the comb-shaped $n^+$-diffusion region 18. The base part 18a has a belt-like shape and is on the order of several μm width for a relatively low resistance value. Each of the wide tooth parts 18b is on the order of several μm width for contact with the power line of $V_{DD}$ through an individual ohmic contact (X) window 20, usually formed in an insulation layer made of, for example, phospho-silicate glass (PSG), mounted on the basic cells. Each of the narrow tooth parts 18c is as narrow as possible, i.e., the minimum width possible with recent semiconductor manufacturing techniques. Similarly, reference numeral 19a represents a base part of the region 19, 19b wide tooth parts of the region 19, and 19c narrow tooth parts of the region 19. Thus the members 19a, 19b, and 19c form the comb-shaped $p^+$-diffusion region 19. The base part 19a has a belt-like shape and is on the order of several μm width for a relatively low resistance value. Each of the wide tooth parts 19b is on the order of several μm width in order for contact with the power line of $V_{SS}$ through an individual ohmic contact (X) window 21 identical to the window 20. Each of the narrow tooth parts 19c is as narrow as possible, i.e., the minimum width possible with recent semiconductor manufacturing techniques.

Each part of the $n^+$- and $p^+$-diffusion regions is formed to be about several thousand Å in depth, almost the same as that of each source and drain of the CMIS transistors comprising each basic cell. Further, as seen from Figure 7A, the wide tooth parts 18b and 19b are located in the column direction with at a pitch corresponding to two successive basic cells 11. The wide tooth parts 18b and 19b may also be located at a pitch corresponding to three or more successive basic cells so long as the capability of suppressing latchup is maintained.

According to the first embodiment of the present invention, the basic cells can be packed at a high degree of density while maintaining a capability for suppressing latchup comparable with the prior art for each basic cell sandwiched by two tooth parts (18b, 18c; 19b, 19c) located close thereto.

The base, wide tooth, and narrow tooth parts (18a, 18b, 18c) of the $n^+$-type can be manufactured at the same time as the source and drain of the n-channel MIS transistors nMIS. Similarly, the base, wide tooth, and narrow tooth parts (19a, 19b, 19c) of the $p^+$-type can be manufactured at the same time as the source and drain of the p-channel MIS transistor pMIS.

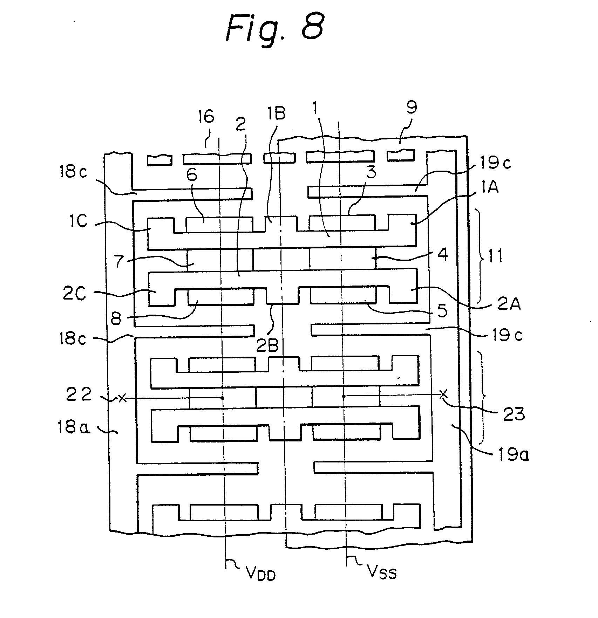

Figure 8 is an enlarged top plan view of a partial basic cell array according to a second embodiment of the present invention. This figure corresponds to Figure 7A of the first embodiment. The major part is substantially the same as Figure 7A. The differences here are that the tooth parts are all formed with the narrow tooth parts 18c and 19c, that is, the wide tooth parts 18b and 19b are removed therefrom. Therefore, the ohmic contact (X) windows 22 and 23 are formed right above the base parts 18a and 19a respectively. Incidentally, while the second embodiment (Figure 8) is superior to the first embodiment from the viewpoint of higher packing of the basic cells since there are no wide tooth parts, it is inferior to the first embodiment in view of design freedom for producing the desired LSI circuit, because the wirings between the power lines and the ohmic contact windows impede free distribution of the desired interconnecting lines.

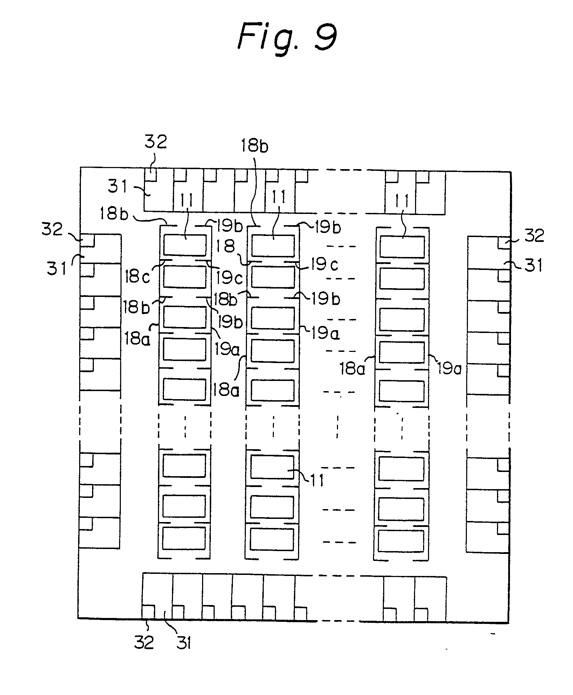

Figure 9 is a schematic top plan view of an example of a gate array type semiconductor integrated circuit device including the comb-shaped diffusion regions according to the first embodiment of Figure 7A. There are many basic arrays inside the semiconductor chip. Each basic cell array is, as a whole, surrounded by the $n^+$-diffusion regions 18a, 18b, 18c and the $p^+$-diffusion regions 19a, 19b, 19c. There are many peripheral circuits outside the basic cell arrays. Each peripheral circuit is chiefly comprised of an interface circuit 31 for interface operation between external circuits and an input/output electrode pad 32.

Finally, advantages of the present invention will be given below with reference to Figure 9. If the semiconductor chip of Figure 9 has a size of 10 mm×10 mm, the length of each basic cell array in the column direction may be 9.6 mm. With a length of 9.6 mm, if the prior art diffusion regions shown in Figure 5 are utilized, 300 basic cells can be accommodated in each basic cell array. Since the pitch $P_1$ (refer to Figure 5) between two successive diffusion regions is usually about 32 μm and the width $W_1$ (refer to Figure 5) of each diffusion region is about 4 μm, the expression 300×32 (μm)=9.6 (mm) stands. Contrary to the above, according to the present invention, while the width $W_1$ (refer to Figure 7A) of each wide tooth part is about 4 μm as in the prior art, the width $W_2$ (refer to Figure 7A) of each narrow tooth part can be halved to about 2 μm. Therefore, the pitch $P_2$ (refer to Figure 7A) between two successive diffusion regions can be reduced to 30 μm. Thus, the pitch $P_2$ becomes shorter by 2 μm than the pitch $P_1$ of the prior art. This means that about 600 μm (=2 μm×300) of chip space can be saved, according to the above mentioned example, in each basic cell array. It should be understood here that the thus saved chip space can accommodate 20 (=600/30) basic cells in each column. Thus clearly assures a highly packing of the basic cells even though the length of the basic cell array remains at 9.6 mm. Conversely, if the number of the basic cells is constant, the chip size can be reduced.

As explained above in detail, a comb-shaped diffusion region comprised of at least narrow tooth parts can save chip space for further basic cells. As previously mentioned, since many narrow tooth parts can be inserted between two adjacent basic cells along the length of the basic cell array, the thus saved chip space necessarily becomes large, which is sufficient to accommodate many further basic cells in each basic cell array.

## Claims

1. A gate array type of semiconductor integrated circuit device formed in a semiconductor substrate (10), comprising an array of basic cells (11) arranged in columns and rows with column spaces (13) between adjacent columns and row spaces (12) between adjacent rows, each of the basic cells (11) including a first-channel MIS transistor ($TR_1$, $TR_2$) formed in the silicon substrate (10) of one conductivity type and a second-channel MIS transistor ($TR_3$, $TR_4$) formed in a well (9) of other conductivity type; a plurality of first diffusion regions (15) of one conductivity type in contact with the semiconductor substrate (10) and located in the row spaces (12) between adjacent basic cells (11) the first diffusion regions (15) being ohmically connected with a first power line ($V_{DD}$), and a plurality of second diffusion regions (14) of the other conductivity type in contact with the wells (9) and located in the row spaces (12) between adjacent basic cells (11), the second diffusion regions (14) being ohmically connected with a second power line ($V_{SS}$), characterised in that both the first (18) and second (19) diffusion regions have a comb-shaped structure arranged with its base (18a, 19a) along the column spaces (13) and its teeth (18b, c, 19b, c) along the row spaces (12).

2. A gate array device according to claim 1, wherein each comb-shaped first (18) and second (19) diffusion region includes wide teeth (18b, 19b) and narrow teeth (18c, 19c) formed as an integral structure, ohmic contacts between the regions (18, 19) and the power lines ($V_{DD}$, $V_{SS}$) being located only on the wide teeth.

3. A gate array device according to claim 1, wherein each of the comb-shaped first (18) and second (19) diffusion regions consists of a base part (18a, 19a) formed along the column spaces and narrow teeth (18c, 19c) formed along the row spaces, as an integral structure, the ohmic contacts between the diffusion regions (18, 19) and the power lines ($V_{DD}$, $V_{SS}$) being formed only in the base parts (18a, 19a).

4. A gate array device according to claim 2 or 3, wherein each said narrow tooth part has a minimum width among the circuit elements fabricated in the same semiconductor substrate.

## Patentansprüche

1. Integrierte Halbleiterschaltung vom Gate-Array-Typ, die in einem Halbleitersubstrat (10) gebildet ist, mit einem Array aus Basiszellen (11), die in Spalten und Reihen mit Spaltenabständen (13) zwischen benachbarten Spalten und Reihenabständen (12) zwischen benachbarten Reihen angeordnet sind, wobei jede der Basiszellen (11) einen Erst-Kanal-MIS-Transistor ($TR_1$, $TR_2$) hat, der in dem Halbleitersubstrat (10) von einem Leitfähigkeitstyp gebildet ist, und einen Zweit-Kanal-MIS-Transistor (TR$_3$, TR$_4$), der in einer Mulde (9) gebildet ist, vom anderen Leitfähigkeitstyp; einer Vielzahl von ersten Diffusionsbereichen (15) von einem Leitfähigkeitstyp in Berührung mit dem Halbleitersubstrat (10) und angeordnet in den Reihenabständen (12) zwischen benachbarten Basiszellen (11), bei der die ersten Diffusionsbereiche (15) ohmisch mit einer ersten Energieleitung (V$_{DD}$) verbunden sind, und einer Vielzahl von zweiten Diffusionsbereichen (14) von dem anderen Leitfähigkeitstyp in Berührung mit der Mulde (9) und in Reihenabständen (12) zwischen benachbarten Basiszellen (11) angeordnet, wobei die zweiten Diffusionsbereiche (14) ohmisch mit einer zweiten Energieleitung (V$_{SS}$) verbunden sind, dadurch gekennzeichnet, daß sowohl die ersten (18) als auch die zweiten (19) Diffusionsbereiche eine kammförmige Struktur haben, die mit ihrer Basis (18a, 19a) längs den Spaltenabständen (13) und mit ihren Zähnen (18b, c, 19b, c) längs den Reihenabständen angeordnet sind.

2. Gate-Array-Vorrichtung nach Anspruch 1, bei der jeder kammförmige erste (18) und zweite (19) Diffusionsbereich breite Zähne (18b, 19b) und schmale Zähne (18c, 19c) umfaßt, die als eine einstückige Struktur ausgebildet sind, und Ohmsche Kontakte zwischen den Bereichen (18, 19) und den Energieleitungen (V$_{DD}$, V$_{SS}$) lediglich auf den breiten Zähnen angeordnet sind.

3. Gate-Array-Vorrichtung nach Anspruch 1, bei der jeder der kammförmigen ersten (18) und zweiten (19) Diffusionsbereiche aus einem Basisteil (18a, 19a) besteht, der längs den Spaltenabständen gebildet ist, und schmalen Zähnen (18c, 19c), die längs den Reihenabständen gebildet sind, als eine einstückige Struktur, wobei die Ohmschen Kontakte zwischen den Diffusionsbereichen (18, 19) und den Energieleitungen (V$_{DD}$, V$_{SS}$) lediglich in den Basisteilen (18a, 19a) gebildet sind.

4. Gate-Array-Vorrichtung nach Anspruch 2 oder 3, bei der jeder genannte schmale Zahn eine minimale Breite Innerhalb der Schaltungselemente hat, die in demselben Halbleitersubstrat hergestellt sind.

## Revendications

1. Dispositif à semiconducteur à circuit intégré du type à matrice de circuits prédiffusés formé dans un substrat semiconducteur (10), comprenant une matrice de cellules de base (11) disposées en colonnes et en lignes, des espaces de colonnes (13) étant prévus entre les colonnes voisines et des espaces de lignes (12) étant prévus entre les lignes voisines, chacune des cellules de base (11) incluant un transistor à métal-isolant-semiconducteur (MIS) à premier canal (TR$_1$, TR$_2$) formé dans le substrat de silicium (10) d'un type de conductivité et un transistor MIS à second canal (TR$_3$, TR$_4$) formé dans un puits (9) d'un autre type de conductivité; un ensemble de premières régions de diffusion (15) d'un type de conductivité en contact avec le substrat semiconducteur (10) et placées dans les espaces de lignes (12) entre les cellules de base (11) voisines, les premières régions de diffusion (15) étant connectées de façon ohmique avec une première ligne d'alimentation (V$_{DD}$), et un ensemble de secondes régions de diffusion (14) de l'autre type de conductivité en contact avec les puits (9) et placées dans les espaces de lignes (12) entre les cellules de base (11) voisines, les secondes régions de diffusion (14) étant connectées de façon ohmique avec une seconde ligne d'alimentation (V$_{SS}$), caractérisé en ce qu'à la fois les premières (18) et les secondes (19) régions de diffusion ont une structure en forme de peigne disposée avec sa base (18a, 19a) le long des espaces de colonnes (13) et ses dents (18b, c, 19b, c) le long des espaces de lignes (12).

2. Dispositif à matrice de circuits prédiffusés selon la revendication 1, dans lequel chaque première région (10) et chaque seconde région (19) en forme de peigne comprend des dents larges (18, 19b) et des dents étroites (18c, 19c) formées comme une structure intégrale, des contacts ohmiques entre les régions (18, 19) et les lignes d'alimentation (V$_{DD}$, V$_{SS}$) n'étant situés que sur les dents larges.

3. Dispositif à matrice de circuit prédiffusés selon la revendication 1, dans lequel chacune des premières (18) et secondes (19) régions de diffusion en forme de peigne est constituée d'une partie de base (18a, 19a) formée le long des espaces de colonnes et de dents étroites (18c, 19c) formées le long des espaces de lignes, comme une structure intégrale, les contacts ohmiques entre les régions de diffusion (18, 19) et les lignes d'alimentation (V$_{DD}$, V$_{SS}$) n'étant formés que dans les parties de base (18a, 19a).

4. Dispositif à matrice de circuits prédiffusés selon l'une quelconque des revendications 2 et 3, dans lequel chaque partie de dent étroite a une largeur minimale parmi les éléments de circuit fabriqués dans le même substrat semiconducteur.

## Fig. 1

## Fig. 2

# Fig. 3

# Fig. 4

## Fig. 5

## Fig. 6A

## Fig. 6B

# Fig. 7A

## Fig. 7B

## Fig. 7C

## Fig. 7D

# Fig. 8

## Fig. 9

7